# EUROPEAN PATENT APPLICATION

(11) **EP 4 451 822 A1**
(43) Date of publication of application: **23.10.2024**
(21) Application number: 22907334.1
(22) Date of filing: 08.12.2022
(51) Int. Cl.: H10K 30/50, H10K 30/40, H10K 30/82, H10K 30/86, H10K 39/15

(54) **PHOTOELECTRIC CONVERSION ELEMENT AND METHOD FOR MANUFACTURING PHOTOELECTRIC CONVERSION ELEMENT**

(30) Priority: 17.12.2021 JP 2021205450
(71) Applicant: Idemitsu Kosan Co.,Ltd., Tokyo 100-8321 (JP); The University of Tokyo, Bunkyo-ku, Tokyo 113-8654 (JP)
(72) Inventor: NAKAMURA, Motoshi, Tokyo 100-8321 (JP); TAKENAKA, Issei, Tokyo 100-8321 (JP); SEGAWA, Hiroshi, Tokyo 113-8654 (JP); TADA, Keishi, Tokyo 113-8654 (JP); BESSHO, Takeru, Tokyo 113-8654 (JP)
(74) Representative: Hoffmann Eitle
(86) International application number: PCT/JP2022/045207
(87) International publication number: WO 2023/112807

(57) **Abstract**

A photoelectric conversion element includes a light absorbing layer, a hole transport layer that transports holes generated by photoexcitation of the light absorbing layer, and a transparent conductive layer that is in contact with the hole transport layer and receives holes from the hole transport layer. The carrier density of the transparent conductive layer is more than 1×10¹⁶ cm⁻³ and 1×10²⁰ cm⁻³ or less.

## Description

### Technical Field

The present invention relates to a photoelectric conversion element and a manufacturing method of a photoelectric conversion element.

### Background Art

In recent years, as one of next-generation solar cells, a perovskite solar cell containing a material having a perovskite structure using lead, tin, or the like as a central metal has attracted attention. The perovskite solar cell exhibiting high efficiency has a so-called n-i-p type laminated structure in which an electron transport layer made of an n-type semiconductor, a perovskite layer, and a hole transport layer made of a p-type semiconductor are arranged in this order from the light-receiving surface side. An organic thin film such as Spiro-OMeTAD is generally applied to the hole transport layer (see, for example, Non Patent Literature 1).

For example, it is known that when a metal electrode of a perovskite solar cell is replaced with a transparent conductive layer to be made semi-transparent for application to a multi-junction solar cell, efficiency is greatly reduced (see, for example, Non Patent Literature 2). As a countermeasure, it is possible to improve the efficiency by introducing MoOₓ or the like as a buffer layer between the hole transport layer and the transparent conductive layer of the perovskite solar cell (See, for example, Non Patent Literature 3 and Non Patent Literature 4) .

### Citation List

### Non Patent Literature

Non Patent Literature 1: Min, H., Kim, M., Lee, S.-U., Kim, H., Kim, G., Choi, K., Lee, J.H., and Seok, S. Il (2019). Efficient, stable solar cells by using inherent bandgap of α-phase formamidinium lead iodide. Science (80-.). 366, 749-753
Non Patent Literature 2: Kanda, H., Uzum, A., Baranwal, A.K., Peiris, T.A.N., Umeyama, T., Imahori, H., Segawa, H., Miyasaka, T., and Ito, S. (2016). Analysis of Sputtering Damage on I-V Curves for Perovskite Solar Cells and Simulation with Reversed Diode Model. J. Phys. Chem. C 120, 28441-28447.
Non Patent Literature 3: Loper, P., Moon, S.J., Martin De Nicolas, S., Niesen, B., Ledinsky, M., Nicolay, S., Bailat, J., Yum, J.H., De Wolf, S., and Ballif, C. (2015). Organic-inorganic halide perovskite/crystalline silicon four-terminal tandem solar cells. Phys. Chem. Chem. Phys. 17, 1619-1629.
Non Patent Literature 4: Duong, T., Lal, N., Grant, D., Jacobs, D., Zheng, P., Rahman, S., Shen, H., Stocks, M., Blakers, A., Weber, K., et al. (2016). Semitransparent Perovskite Solar Cell With Sputtered Front and Rear Electrodes for a Four-Terminal Tandem. IEEE J. Photovoltaics 6, 679-687.

### Summary of Invention

### Technical Problem

However, when a buffer layer such as MoOₓ is formed between the hole transport layer of the perovskite solar cell and the transparent conductive layer of the anode, heat resistance is reduced, light transmittance is reduced, and the film formation step at the time of production becomes complicated.

The present invention has been made in view of the above circumstances, and provides a photoelectric conversion element capable of improving the efficiency of photoelectric conversion without forming a buffer layer between a hole transport layer and a transparent conductive layer.

### Solution to Problem

A photoelectric conversion element according to an aspect of the present invention includes a light absorbing layer, a hole transport layer that transports holes generated by photoexcitation of the light absorbing layer, and a transparent conductive layer that is in contact with the hole transport layer and receives holes from the hole transport layer. The carrier density of the transparent conductive layer is more than 1×10¹⁶ cm⁻³ and 1×10²⁰ cm⁻³ or less.

### Advantageous Effects of Invention

According to one aspect of the present invention, it is possible to provide a photoelectric conversion element capable of improving the efficiency of photoelectric conversion without forming a buffer layer between a hole transport layer and a transparent conductive layer.

### Brief Description of Drawings

Fig. 1 is a cross-sectional view in a thickness direction illustrating an example of a solar cell of the present embodiment.
Fig. 2 is a cross-sectional view in a thickness direction illustrating another example of the solar cell of the present embodiment.
Fig. 3 is a schematic diagram illustrating a perovskite structure.
Fig. 4 is a diagram illustrating an electron level connection model of a transparent conductive layer and a hole transport layer.
Fig. 5 is a diagram illustrating a simulation result of device characteristics with respect to a carrier density of a hole transport layer.
Fig. 6 is a diagram illustrating device characteristics with respect to the thickness of the hole transport layer.
Fig. 7 is a diagram illustrating various device characteristics of examples and comparative examples.

### Description of Embodiments

Hereinafter, embodiments will be described with reference to the drawings.

In the embodiment, for ease of description, structures or elements other than the main parts of the present invention will be described in a simplified or omitted manner. In the drawings, the same elements are denoted by the same reference numerals. In the drawings, shapes, dimensions, and the like of each element are schematically illustrated, and do not indicate actual shapes, dimensions, and the like.

### <Configuration Example of Photoelectric Conversion Element>

Next, a configuration example of a solar cell which is an example of a photoelectric conversion element of the present embodiment will be described with reference to the drawings. The photoelectric conversion element of the present embodiment is a perovskite solar cell using a photoelectric conversion material having a perovskite structure for a light absorbing layer. The solar cell of the present embodiment may have either a configuration of a single-junction cell or a configuration of a multi-junction cell in which a top cell and a bottom cell are stacked.

In the following description, the overall configuration of a solar cell in the case of a single-junction cell and a solar cell in the case of a multi-junction cell will be described, and then the structure of a perovskite solar cell common to both will be described in detail.

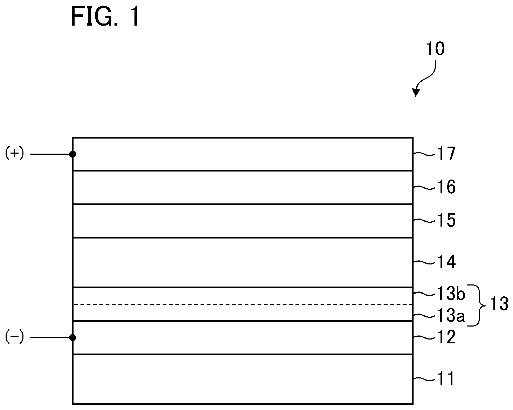

Fig. 1 is a sectional view in a thickness direction illustrating an example of a single-junction perovskite solar cell.

A solar cell 10 of Fig. 1 has a laminated structure in which a first conductive layer 12, an electron transport layer 13, a light absorbing layer 14, a hole transport layer 15, a second conductive layer 16, and a third conductive layer 17 are sequentially laminated on a substrate 11 from the bottom (substrate side).

The substrate 11 illustrated in Fig. 1 can be selected from a transparent glass substrate such as soda-lime glass or alkali-free glass, a resin substrate, a metal substrate, a ceramic substrate, and the like, and a commercially available product can be suitably used. The substrate 11 may be either a substrate having no translucency or a substrate having translucency. Note that the substrate 11 may be a flexible substrate.

Here, in the present specification, "having translucency" means that 10% or more of light having any wavelength of 200 nm to 2000 nm is transmitted.

In a case where the substrate 11 has translucency, light may be incident on the solar cell 10 from the substrate 11 side (lower side in the drawing) or from the third conductive layer 17 side (upper side in the drawing). On the other hand, in a case where the substrate 11 does not have translucency, light enters the solar cell 10 from the third conductive layer 17 side (upper side in the drawing).

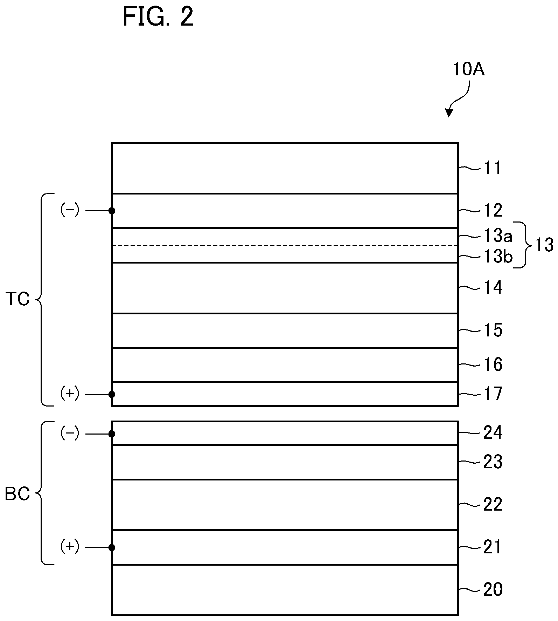

Fig. 2 is a cross-sectional view in a thickness direction illustrating an example of a multi-junction solar cell including a perovskite solar cell. A solar cell 10A of Fig. 2 has a laminated structure in which a top cell TC and a bottom cell BC are laminated. In the configuration of Fig. 2, light enters the solar cell 10A from the top cell TC side (upper side in the drawing). In the top cell TC, light on a short wavelength side of incident light is photoelectrically converted. In addition, in the bottom cell BC, light on the long wavelength side transmitted through the top cell TC in the incident light is photoelectrically converted.

The top cell TC is a perovskite solar cell layer. The top cell TC has a laminated structure in which the substrate 11, the first conductive layer 12, the electron transport layer 13, the light absorbing layer 14, the hole transport layer 15, the second conductive layer 16, and the third conductive layer 17 are sequentially laminated in this order from the upper side (light-receiving surface side) in the drawing. The substrate 11 in the top cell TC in Fig. 2 is a substrate having translucency.

The bottom cell BC is a solar cell layer having a laminated structure in which a substrate 20, a first electrode layer 21, a photoelectric conversion layer 22, a buffer layer 23, and a second electrode layer 24 are sequentially laminated from the bottom in the drawing (opposite side of the light-receiving surface). As the bottom cell BC, for example, a configuration of a compound solar cell such as a CZTS solar cell, a CIGS solar cell, a CdTe solar cell, or a GaAs solar cell, or a known solar cell such as a silicon solar cell or an organic solar cell can be applied. Therefore, description of the configuration of the bottom cell BC is omitted. The buffer layer 23 of the bottom cell BC may be omitted.

Next, the first conductive layer 12, the electron transport layer 13, the light absorbing layer 14, the hole transport layer 15, the second conductive layer 16, and the third conductive layer 17 included in the perovskite solar cell will be described in detail.

### (First Conductive Layer 12)

The first conductive layer 12 is a layer that acts as a cathode of the solar cell, and is formed by being laminated on the substrate 11.

Examples of the material of the first conductive layer 12 include conductive transparent materials such as copper iodide (CuI), indium tin oxide (ITO), tin oxide (SnO₂), fluorine doped tin oxide (FTO), aluminum doped zinc oxide (AZO), indium zinc oxide (IZO), and gallium doped zinc oxide (GZO); metallic sodium, a sodium-potassium alloy, metallic lithium, metal magnesium, metal aluminum, a magnesium-silver mixture, a magnesium-indium mixture, an aluminum-lithium alloy, an aluminum-aluminum oxide (Al/Al₂O₃) mixture, and an aluminum-lithium fluoride (Al/LiF) mixture. The above materials may be used alone, or may be a mixture of two or more kinds.

The first conductive layer 12 preferably has translucency. However, in the case of the solar cell 10 in which the substrate 11 does not have translucency and light enters from the third conductive layer 17 side, the first conductive layer 12 may not have translucency.

The first conductive layer 12 can be formed by, for example, a known film forming method such as a vapor deposition method or a sputtering method. Although not particularly limited, the thickness of the first conductive layer 12 is preferably in the range of 0.1 um to 5.0 um. When the thickness of the first conductive layer 12 is less than 0.1 um, it is difficult to obtain sufficient conductivity. On the other hand, when the thickness of the first conductive layer 12 exceeds 5.0 um, the light transmittance of the first conductive layer 12 decreases, and the photoelectric conversion efficiency tends to decrease.

### (Electron Transport Layer 13)

The electron transport layer 13 has a function of transporting electrons generated by photoexcitation of the light absorbing layer 14 to the first conductive layer 12. Therefore, the electron transport layer 13 is formed of a material having characteristics that electrons generated in the light absorbing layer 14 can easily move to the electron transport layer 13 and electrons of the electron transport layer 13 can easily move to the first conductive layer 12.

Examples of the material of the electron transport layer 13 include not only inorganic materials such as titanium oxide (TiO₂), tungsten oxides (WO₂, WO₃, W₂O₃, or the like), zinc oxide (ZnO), niobium oxide (Nb₂O₅ or the like), tantalum oxide (Ta₂O₅ or the like), yttrium oxide (Y₂O₃ or the like), strontium titanate (SrTiOs or the like), and tin oxide (SnO₂), but also organic materials such as fullerenes (C60, C70, or the like) and derivatives thereof (PC₆₀BM, PC₇₀BM, ICBA, hydrogenated C60, hydroxylated C60, or the like). The above materials may be used alone, or may be a mixture of two or more kinds.

The electron transport layer 13 may have a single layer structure, but preferably has a laminated structure including a dense layer 13a having a dense structure and a porous layer 13b having a porous structure. In the electron transport layer 13, the dense layer 13a is formed so as to face the first conductive layer 12 and the porous layer 13b, and the porous layer 13b is formed to face the dense layer 13a and the light absorbing layer 14.

The dense layer 13a is a layer constituting the electron transport layer 13 together with the porous layer 13b, has fewer voids than the porous layer 13b, and is a layer into which a solution or the like does not infiltrate when the light absorbing layer 14 is formed. The dense layer 13a has a function of preventing contact between the first conductive layer 12 and the second conductive layer 16, which causes a decrease in photovoltaic power, and a function of preventing contact between the first conductive layer 12 and the hole transport layer 15. Therefore, by providing the dense layer 13a, a decrease in photovoltaic power can be suppressed.

The thickness of the dense layer 13a is, for example, preferably in a range of 5 nm to 200 nm, and more preferably in a range of 10 nm to 100 nm.

As an example, in a case where the electron transport layer 13 is formed of titanium oxide, the dense layer 13a can be formed by the following manufacturing method. First, a coating liquid containing a titanium chelate compound is prepared, and the coating liquid is applied onto the first conductive layer 12 by a film forming method such as a spin coating method, a screen printing method, a spray pyrolysis method, or an aerosol deposition method. Thereafter, the dense layer 13a of titanium oxide is formed by performing firing. In addition, after the firing, the dense layer 13a made of titanium oxide may be immersed in an aqueous solution of titanium tetrachloride. Thus, the denseness of the dense layer 13a can be increased.

As the titanium chelate compound that can be used for forming the dense layer 13a of titanium oxide, a compound having an acetoacetic acid ester chelate group or a compound having a β-diketone chelate group is preferable.

Among the above titanium chelate compounds, compounds having an acetoacetic acid ester chelate group include diisopropoxytitanium bis (methylacetoacetate), diisopropoxytitanium bis (ethylacetoacetate), diisopropoxytitanium bis (propylacetoacetate), diisopropoxytitanium bis (butylacetoacetate), dibutoxytitanium bis (methylacetoacetate), dibutoxytitanium bis (ethylacetoacetate), triisopropoxytitanium (methylacetoacetate), triisopropoxytitanium (ethylacetoacetate), tributoxytitanium (methylacetoacetate), tributoxytitanium (ethylacetoacetate), isopropoxytitanium tri(methylacetoacetate), isopropoxytitanium tri(ethylacetoacetate), isobutoxytitanium tri(methylacetoacetate), and isobutoxytitanium tri(ethyl acetoacetate), and the like. In addition, among the titanium chelate compounds listed above, compounds having a β-diketone chelate group include diisopropoxytitanium bis (acetylacetonate), diisopropoxytitanium bis (2,4-heptanedionate), dibutoxytitanium bis (acetylacetonate), dibutoxytitanium bis (2,4-heptanedionate), triisopropoxytitanium (acetylacetonate), triisopropoxytitanium (2,4-heptanedionate), tributoxytitanium (acetylacetonate), tributoxytitanium (2,4-heptanedionate), isopropoxytitanium tri(acetylacetonate), isopropoxytitanium tri(2,4-heptanedionate), isobutoxytitanium tri(acetylacetonate), and isobutoxytitanium tri(2,4-heptanedionate). The material of the dense layer 13a is not limited thereto.

On the other hand, the porous layer 13b has larger voids than the dense layer 13a, and is a layer into which a solution or the like infiltrates when the light absorbing layer 14 is formed. The material of the light absorbing layer 14 is filled into and held in the pores of the porous layer 13b. Therefore, the porous layer 13b has a function of expanding a contact area between the electron transport layer 13 and the light absorbing layer 14 and efficiently transferring electrons generated by photoexcitation in the light absorbing layer 14 to the electron transport layer 13. As a result, electrons generated by photoexcitation in the light absorbing layer 14 can be efficiently charge separated by the porous layer 13b, and recombination of electrons and holes can be suppressed. As a result, the photoelectric conversion efficiency of the solar cell can be improved.

The thickness of porous layer 13b is, for example, preferably in a range of 10 nm to 2000 nm, and more preferably in a range of 20 nm to 500 nm.

As an example, when the electron transport layer 13 is formed of titanium oxide, the porous layer 13b can be formed by the following manufacturing method. First, for example, a coating liquid containing titanium oxide particles is prepared, and the coating liquid is applied onto the dense layer 13a by a film forming method such as a spin coating method, a screen printing method, a spray pyrolysis method, or an aerosol deposition method. Thereafter, the porous layer 13b of titanium oxide is formed by performing firing. When the coating liquid contains an organic binder, the organic binder needs to be eliminated by a firing treatment.

Here, there are several crystal types of titanium oxide, but in the case of forming the porous layer 13b of titanium oxide, it is preferable to use anatase type titanium oxide particles.

The coating liquid used for forming the porous layer 13b of titanium oxide can be prepared, for example, by dispersing titanium oxide particles (such as P-25 manufactured by NIPPON AEROSIL CO., LTD.) in alcohol (such as ethanol) or diluting a titanium oxide paste (such as PS5-24NRT manufactured by JGC Catalysts and Chemicals Ltd.) with alcohol (such as ethanol).

The organic binder that can be used in the coating liquid is not particularly limited, but ethyl cellulose and an acrylic resin are preferable. The acrylic resin is particularly preferable because it is excellent in low-temperature decomposability and has a small amount of organic residues even when low-temperature firing is performed. The acrylic resin is preferably one that decomposes at a low temperature of about 300°C. For example, a polymer obtained by polymerizing at least one (meth)acrylic monomer selected from the group consisting of methyl (meth)acrylate, ethyl (meth)acrylate, propyl (meth)acrylate, n-butyl (meth)acrylate, tert-butyl (meth)acrylate, isobutyl (meth)acrylate, cyclohexyl (meth)acrylate, 2-ethylhexyl (meth)acrylate, isoboronyl (meth)acrylate, n-stearyl (meth)acrylate, benzyl (meth)acrylate, and a (meth)acrylic monomer having a polyoxyalkylene structure is suitably used.

In a case where the porous layer 13b is formed of titanium oxide, the pore diameter of the porous layer 13b can be adjusted by changing the particle diameter of the titanium oxide particles or changing the type and addition amount of the organic binder.

### (Light Absorbing Layer 14)

The light absorbing layer 14 contains a compound having a perovskite structure, and has a function of absorbing incident light to generate electrons and holes. In the light absorbing layer 14, low-energy electrons in a substance constituting the light absorbing layer are photoexcited by incident light, and higher-energy electrons and holes are generated. Electrons generated by photoexcitation move to the electron transport layer 13, and holes generated by photoexcitation move to the hole transport layer 15, whereby charge separation is performed.

The compound having a perovskite structure has a property derived from an inorganic material, and thus has higher durability than a light absorbing layer composed of an organic material.

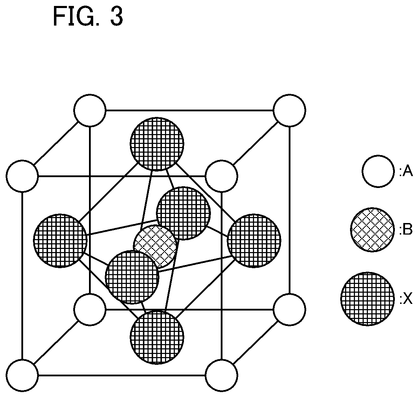

The basic unit lattice of the perovskite-type crystal structure is shown as in Fig. 3. The compound having a perovskite structure that can be used for the light absorbing layer 14 has a cubic basic unit lattice. An organic group A is disposed at each apex of the cubic crystal, a metal B is disposed at the body center, and a halogen X is disposed at each face center of the cubic crystal centered on the metal B. The compound having the perovskite structure is represented by the general formula A-B-X₃.

In the general formula A-B-X₃, specific examples of the organic group A include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, formamidine, imidazole, azole, pyrrole, aziridine, azirine, azetidine, azeto, azole, imidazoline, carbazole, ions thereof (for example, methylammonium (CH₃NH₃) or the like) and phenethylammonium. These organic groups may be used singly or in combination of two or more kinds thereof. Among them, methylamine, ethylamine, propylamine, butylamine, pentylamine, hexylamine, formamidine, ions thereof, and phenethylammonium are preferable, and methylamine, formamidine, and ions thereof (for example, methylammonium (CH₃NH₃), formamidium (CHN₂H₄), and the like) are more preferable. Specific examples of the metal A include lithium, sodium, potassium, rubidium, and cesium. These metals may be used singly or in combination of two or more kinds thereof. Two or more kinds of organic groups and metals may be used simultaneously.

In the general formula A-B-X₃, specific examples of the metal B include lead, tin, zinc, titanium, antimony, bismuth, nickel, iron, cobalt, silver, copper, gallium, germanium, magnesium, calcium, indium, aluminum, manganese, chromium, molybdenum, and europium. Among them, it is preferable that the metal B is lead because the light absorbing layer 14 has good characteristics. These elements may be used singly or in combination of two or more kinds thereof.

In the general formula A-B-X₃, the halogen X is chlorine, bromine or iodine, and these elements may be used alone or in combination of two or more thereof. Among them, it is preferable that X contains iodine because the energy band gap is narrowed.

The light absorbing layer 14 is preferably a layer containing a compound having a perovskite structure represented by the formula (CHN₂H₄)ₚ(CH₃NH₃)_{q}AᵣPbX₃. In the formula, X is a halogen atom, A is Na, K, Rb, and Cs, r is a number represented by 0 ≤ q ≤ 1, q is a number represented by 0 ≤ y ≤ 1, p is a number represented by 0 ≤ p ≤ 1, and p + q + r = 1.

In the compound represented by the above formula (CHN₂H₄)ₚ(CH₃NH₃)_{q}AᵣPbX₃, it is more preferable that X contains iodine.

The compound having a perovskite structure that can be used as the light absorbing layer 14 can be synthesized using a compound represented by AX and a compound represented by BX₂ as raw materials. Specifically, a compound having a perovskite structure can be synthesized by mixing and stirring an AX solution and a BX₂ solution (one-step method). The compound having a perovskite structure can be synthesized by, for example, applying a BX₂ solution onto the porous layer 13b to form a coating film, applying an AX solution onto the coating film, and reacting BX₂ with AX (two-step method). Both the one-step method and the two-step method can be used for forming the light absorbing layer 14. The method for applying the solution is not particularly limited, but a spin coating method, a screen printing method, a dip coating method, or the like can be applied.

### (Hole Transport Layer 15)

The hole transport layer 15 is a layer facing the light absorbing layer 14 and the second conductive layer 16. The hole transport layer 15 has a function of capturing holes generated in the light absorbing layer 14 and moving the holes to the second conductive layer 16 as an anode. The hole transport layer 15 includes a matrix component composed of 2,2', 7,7'-tetrakis-(N, N-di-p-methoxyphenylamine)9,9'-spirobifluorene (Spiro-OMeTAD) or poly[bis (4-phenyl) (2,4,6-trimethylphenyl) amine] (PTAA). Note that a passivate layer (not illustrated) made of a metal oxide or an organic thin film may be provided between the light absorbing layer 14 and the hole transport layer 15 in order to suppress recombination of holes and electrons.

In addition, the hole transport layer 15 has a characteristic that the carrier density is 1×10¹⁸ cm⁻³ or more. By setting the carrier density of the hole transport layer 15 to 1×10¹⁸ cm⁻³ or more, a tunnel effect is easily obtained between the hole transport layer 15 and the second conductive layer 16. This point will be described later.

In addition, the hole transport layer 15 contains an additive that oxidizes the hole transport layer 15 to increase the carrier density. The additive includes lithium (Li). As an example, lithium (fluorosulfonyl)(trifluoromethyl)imide (LiTFSI) can be applied as the additive. In addition, the lithium concentration of the additive is preferably 0.6 or more in terms of a concentration ratio (molar ratio) to a matrix component which is a material of the hole transport layer 15.

The thickness of the hole transport layer 15 is preferably in a range of 20 nm to 500 nm, and more preferably in a range of 70 nm or more and 130 nm or less.

For example, when the hole transport layer 15 is formed of Spiro-OMeTAD, if the thickness of the hole transport layer 15 is 130 nm or less, Spiro-OMeTAD is easily oxidized by oxygen plasma when the second conductive layer 16 is formed by sputtering. The carrier density of the hole transport layer 15 can be further improved by oxidation of Spiro-OMeTAD.

The hole transport layer 15 may be an amorphous layer. In addition, the hole transport layer 15 may contain an organic binder resin, a plasticizer, and the like.

The hole transport layer 15 can be formed by, for example, the following manufacturing method. First, a compound of the matrix component is dissolved in an organic solvent to prepare a coating liquid, and the coating liquid is applied onto the light absorbing layer 14 (or the passivate layer). Thereafter, the organic solvent is removed to form the hole transport layer 15. Since the organic solvent used at the time of forming the hole transport layer 15 is applied onto the light absorbing layer 14, a solvent that does not disturb the crystal structure of the organic-inorganic hybrid compound is preferable. Specific examples thereof include chlorobenzene and toluene. The coating method of the coating liquid is not particularly limited, and examples thereof include a spin coating method, a screen printing method, and a dip coating method.

### (Second Conductive Layer 16)

The second conductive layer 16 is a transparent conductive layer having translucency, and acts as an anode of a solar cell. The second conductive layer 16 is formed on the hole transport layer 15 and is in contact with the hole transport layer 15. In addition, the second conductive layer 16 of the present embodiment has a characteristic that the carrier density is more than 1×10¹⁶ cm⁻³ and 1×10²⁰ cm⁻³ or less.

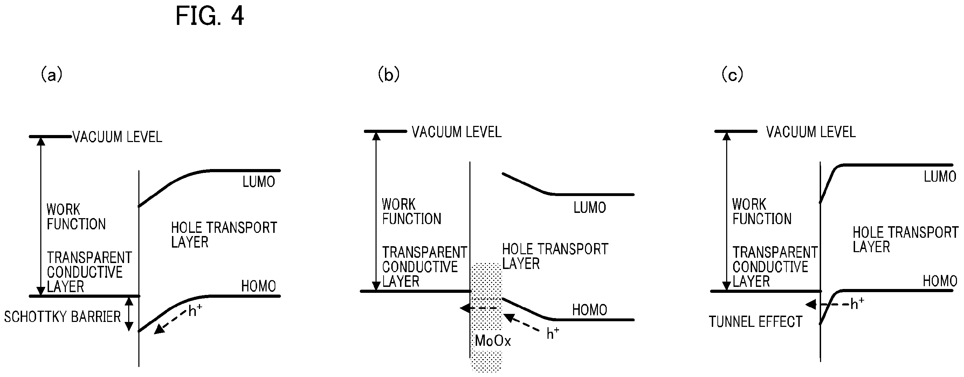

Fig. 4 is a diagram illustrating an electron level connection model of a transparent conductive layer and a hole transport layer. Fig. 4(a) illustrates a configuration of a first comparative example, and Fig. 4(b) illustrates a configuration of a second comparative example. On the other hand, Fig. 4(c) illustrates a configuration of the second conductive layer 16 and the hole transport layer 15 of the present embodiment.

As illustrated in Fig. 4(a), in the structure in which the transparent conductive layer and the hole transport layer are in contact with each other, a Schottky barrier is formed at a junction interface between the transparent conductive layer and the hole transport layer. Therefore, the flow of holes from the hole transport layer to the transparent conductive layer is hindered by the Schottky barrier, and efficiency is reduced.

In addition, as illustrated in Fig. 4(b), when a buffer layer such as molybdenum oxide is formed between the transparent conductive layer and the hole transport layer, the band of the hole transport layer is bent in a direction approaching the vacuum level by the Fermi level of molybdenum oxide. Therefore, in the case of Fig. 4(b), the Schottky barrier as in Fig. 4(a) is not formed. However, in the case of Fig. 4(b), in addition to an increase in the number of film formation steps for forming the buffer layer, a decrease in heat resistance and a decrease in translucency due to the thin film of molybdenum oxide may occur. In particular, in a case where the perovskite solar cell is used as the top cell of the multi-junction cell, a decrease in the translucency of the top cell leads to a decrease in the efficiency of the entire multi-junction cell.

On the other hand, in the configuration of the present embodiment illustrated in Fig. 4(c), the carrier density of the transparent conductive layer is set to more than 1×10¹⁶ cm⁻³ and 1×10²⁰ cm⁻³ or less, and the carrier density of the transparent conductive layer is reduced as compared with the hole transport layer. As a result, in the transparent conductive layer illustrated in Fig. 4(c), a tunnel effect is exhibited at a junction interface between the transparent conductive layer and the hole transport layer by joining with the hole transport layer having an increased carrier density, and holes can be moved from the hole transport layer to the transparent conductive layer. Therefore, it can be seen that in the configuration of the present embodiment illustrated in Fig. 4(c), a decrease in efficiency due to the Schottky barrier can be resolved without forming a buffer layer.

As a material of the second conductive layer 16, a known conductive transparent material can be used, but a metal oxide containing any of indium, zinc, and tin is preferable. Examples of the material of the second conductive layer 16 include conductive transparent materials such as copper iodide (CuI), indium tin oxide (ITO), tin oxide (SnO₂), fluorine-doped tin oxide (FTO), aluminum-doped zinc oxide (AZO), indium zinc oxide (IZO), and gallium-doped zinc oxide (GZO); and conductive transparent polymers.

The second conductive layer 16 of the present embodiment is formed on the hole transport layer 15 by a sputtering method. When the second conductive layer 16 is formed by a sputtering method, the hole transport layer 15 containing an additive is exposed to oxygen plasma by sputtering discharge and oxidized. This makes it possible to improve the carrier density by oxidizing the hole transport layer 15 at the time of forming the second conductive layer 16.

Here, from the viewpoint of promoting oxidation of the hole transport layer 15, the discharge power density during sputtering film formation of the second conductive layer 16 is preferably 0.8 W/cm² or more. In addition, in the sputtering of the second conductive layer 16, the oxygen concentration (oxygen/(carrier gas + oxygen)) of the carrier gas introduced into the sputtering device for generating oxygen plasma is preferably 0.5% or more.

For example, in a case where the material of the second conductive layer 16 is ITO, the thickness of the second conductive layer 16 is preferably in the range of 5 nm to 1000 nm, and more preferably in the range of 10 nm to 100 nm.

### (Third Conductive Layer 17)

The third conductive layer 17 is an auxiliary electrode layer formed by being laminated on the second conductive layer 16. The third conductive layer 17 has a function of reducing the resistance of the entire anode electrode and improving the conductivity that is insufficient when the anode electrode is constituted only by the second conductive layer 16. The third conductive layer 17 may be a transparent electrode or a collecting electrode such as a metal grid. In a case where the third conductive layer 17 is a transparent electrode, the material thereof may be the same as the material of the second conductive layer 16, or may be a different material from the second conductive layer 16.

In addition, in a case where the third conductive layer 17 is a transparent electrode, the carrier density of the third conductive layer 17 may be any value. However, from the viewpoint of enhancing the efficiency of the device, the carrier density of the third conductive layer 17 is preferably more than 1×10²⁰ cm⁻³. From the viewpoint of securing translucency in the third conductive layer 17, the carrier density of the third conductive layer 17 is preferably 1×10²² cm⁻³ or less.

As a material of the third conductive layer 17, a conventionally known electrode material can be used. Examples thereof include metal materials such as gold, silver, copper, aluminum, and nickel; conductive transparent materials such as copper iodide (CuI), indium tin oxide (ITO), tin oxide (SnO₂), fluorine-doped tin oxide (FTO), aluminum-doped zinc oxide (AZO), indium zinc oxide (IZO), and gallium-doped zinc oxide (GZO); and conductive transparent polymers. The above materials may be used alone, or may be a mixture of two or more kinds.

The third conductive layer 17 can be manufactured, for example, by forming a film of an anode material on the second conductive layer 16 by a normal method such as vapor deposition or printing. In addition, the mesh-shaped or grid-shaped third conductive layer 17 may be formed using a deposition mask or the like.

As described above, the solar cell of the above embodiment includes the hole transport layer 15 that transports holes generated by photoexcitation of the light absorbing layer 14, and the transparent conductive layer 16 that is in contact with the hole transport layer 15 and receives holes from the hole transport layer 15.

In the above embodiment, the carrier density of the transparent conductive layer 16 is set to a range of more than 1×10¹⁶ cm⁻³ and 1×10²⁰ cm⁻³ or less, and the carrier density of the transparent conductive layer is reduced as compared with the hole transport layer, so that a tunnel effect can be exhibited at the junction interface with the hole transport layer 15, and holes can be moved from the hole transport layer 15 to the transparent conductive layer 16. This makes it possible to eliminate a decrease in efficiency due to the Schottky barrier and improve the efficiency of photoelectric conversion without forming a buffer layer. In the above embodiment, it is possible to suppress a decrease in heat resistance and a decrease in translucency associated with the formation of the buffer layer, and it is also possible to simplify the film forming step.

### <Description of Examples>

Next, examples of the perovskite solar cell of the above embodiment will be described.

In Examples, a single-junction cell solar cell to be evaluated was manufactured by the following steps (1) to (7) .

### (1) Substrate and First Conductive Layer

A glass substrate (thickness: 1.1 mm) in which a fluorine-doped SnO₂ conductive film (FTO deposited film) was deposited in a thickness of 750 nm was prepared. The glass substrate was cut into a size of 25 mm×25 mm. After cutting, UV light irradiation was performed for 30 minutes.

### (2) Dense Layer of Electron Transport Layer

First, a 75 mass% 1-butanol solution of diisopropoxytitanium bis (acetylacetonate) (Titanium (IV) bis (acetylacetonate) diisopropoxide) (manufactured by Sigma-Aldrich) was diluted with 1-butanol to prepare a coating liquid for a dense layer having a titanium chelate compound concentration of 0.02 mol/L. Next, the coating liquid for the dense layer was applied onto the FTO deposited film of the glass substrate obtained in the step (1) by a spraying method. Thereafter, the coating layer of the coating liquid was heated at 400°C or higher and 500°C or lower for 10 minutes to form a dense layer of titanium oxide having a film thickness of about 50 nm.

### (3) Porous Layer of Electron Transport Layer

First, 0.6 g of an ethanol dispersion of titanium oxide (PS5-24NRT manufactured by JGC Catalysts and Chemicals Ltd.) was diluted with 4.2 g of ethanol to prepare a coating liquid for a porous layer. Next, the coating liquid for a porous layer was applied onto the dense layer obtained in the step (2) by a spin coating method, and then fired. The firing conditions were 550°C and 15 minutes.

Next, 28.7 mg of lithium bis (trifluoromethane) sulfonimide salt (Li-TFSI) (manufactured by Sigma-Aldrich) was dissolved in 1 mL of acetonitrile to prepare a dope coating liquid. Then, the coating liquid for doping was applied by a spin coating method and then fired. The firing conditions were 450°C and 30 minutes. Thus, a porous layer of titanium oxide having a thickness of 100 nm to 200 nm was formed.

### (4) Light Absorbing Layer

First, 529 mg of PbI₂ (manufactured by Tokyo Chemical Industry Co., Ltd.), 74.3 mg of PbBr₂ (manufactured by Tokyo Chemical Industry Co., Ltd.), 22.7 mg of MABr (manufactured by GreatCell Solar), and 188 mg of FAI (manufactured by Tokyo Chemical Industry Co., Ltd.) were dissolved in a mixed solvent of 0.8 mL of N, N-dimethylformamide (DMF) (manufactured by FUJIFILM Wako Pure Chemical Corporation) and 0.2 mL of dimethyl sulfoxide (DMSO) (manufactured by FUJIFILM Wako Pure Chemical Corporation) to prepare a precursor liquid. To this precursor liquid, a solution obtained by dissolving 249 mg of potassium iodide (manufactured by Tokyo Chemical Industry Co., Ltd.) in 1 mL of DMSO was added at a volume ratio of 5% to prepare a coating liquid.

Then, the coating liquid was applied onto the porous layer obtained in the step (3) by a spin coating method to form a coating film. In addition, during the application of the coating liquid by the spin coating method, 0.7 mL of chlorobenzene was dropped into the center of the substrate. Then, the coating film was fired on a hot plate. It was confirmed that the coating film was immediately changed from tan to black by firing, and a compound having a perovskite-type crystal structure was formed. In this way, a light absorbing layer was formed by a one-step method.

### (5) Hole Transport Layer

First, Spiro-OMeTAD (manufactured by Sigma-Aldrich) was weighed, and chlorobenzene was added so as to be 72.3 mg/mL to dissolve the Spiro-OMeTAD, thereby obtaining a solution A. In addition, 520 mg of Li-TFSI (manufactured by Sigma-Aldrich Co. LLC.) was weighed, and 1 mL of acetonitrile (manufactured by Sigma-Aldrich Co. LLC.) was added and dissolved to obtain a solution B.

Next, 17.5 µL of the solution B was added to 1 mL of the solution A, 28.75 µL of 4-tert-butylpyridine (manufactured by Sigma-Aldrich) was further added thereto, and the mixture was stirred. This solution was applied onto the light absorbing layer obtained in the step (4) by a spin coating method. Then, the coating film was heated and dried to remove the organic solvent, thereby forming a hole transport layer having a thickness of about 180 nm with a Li/Spiro molar ratio of 0.54.

In the step (5), the same step as described above was performed using solutions in which the concentration of the solution A was changed to 36.5 mg/mL, 57.8 mg/mL, and 48.2 mg/mL. Thus, hole transport layers in which the molar ratio of Li/Spiro was adjusted to 0.67, 0.81, and 1.07, respectively, were formed.

### (6) Second Conductive Layer

On each hole transport layer obtained in the step (5), ITO was formed as an anode by DC sputtering to prepare an organic-inorganic hybrid photoelectric conversion element. In DC sputtering, Ar gas containing 5% of hydrogen was used as a carrier gas, and oxygen gas was added so that an O/(Ar + O) ratio was 0%, 0.5%, 1.5%, or 2.5%. As a result, ITO having different physical property values of carrier density of 4×10²⁰ cm⁻³, 1×10²⁰ cm⁻³, 1.5×10¹⁹ cm⁻³, and 6×10¹⁶ cm⁻³ was formed. The base pressure during film formation was adjusted to 0.5 Pa, and the film was formed at an output of 1.6 W/cm². The deposition time was adjusted so that each of the second conductive layers had a thickness of 50 nm.

### (7) Third Conductive Layer

ITO was formed as a third conductive layer on each of the second conductive layers obtained in the step (6) by DC sputtering. In the DC sputtering, Ar gas containing 5% of hydrogen was used as a carrier gas, 1% of oxygen gas was added at an O/(Ar + O) ratio, and the film formation time was adjusted so that the film thickness was 250 nm.

### (Carrier Density of Transparent Conductive Layer and Device Characteristics)

In the solar cell to be evaluated obtained in the above step, the relationship between the device characteristics of the solar cell and the carrier density N of the transparent conductive layer in contact with the hole transport layer is shown in Table 1. J_{sc} represents a short circuit current, V_{oc} represents an open circuit voltage, and FF represents a fill factor.

**[Table 1]**

| Transparent conductive layer N (cm⁻³) | Efficiency (%) | J_{SC} (mA cm⁻²) | V_{OC} (mV) | FF(%) |
|---|---|---|---|---|
| 3 × 10²⁰ < N | 6.4 | 18.5 | 1184.3 | 29.1 |
| 1 × 10²⁰< N ≤ 3 × 10²⁰ | 9.7 | 19.8 | 1162.6 | 42.1 |
| 1 × 10¹⁹< N ≤ 1 × 10²⁰ | 15.3 | 20.2 | 1143.9 | 66.3 |
| 1 × 10¹⁶< N ≤ 1 × 10¹⁹ | 15.3 | 20.3 | 1131.9 | 66.6 |
| 1 × 10¹⁴< N ≤ 1 × 10¹⁶ | 9.3 | 21.1 | 897.7 | 49.0 |

As shown in Table 1, when the carrier density N of the transparent conductive layer is in a range of more than 1×10¹⁶ cm⁻³ and 1×10²⁰ cm⁻³ or less, higher efficiency than other ranges can be obtained. As described above, it can be seen that the carrier density N of the transparent conductive layer in contact with the hole transport layer is preferably in a range of more than 1×10¹⁶ cm⁻³ and 1×10²⁰ cm⁻³ or less in order to exhibit the tunnel effect.

### (Dope Concentration of Hole Transport Layer and Device Characteristics)

In the solar cell to be evaluated, the relationship between the device characteristics of the solar cell and the doping concentration of the hole transport layer is shown in Table 2. In the example of Table 2, each of the second conductive layers in contact with the hole transport layer is a transparent conductive layer having a carrier density N of 6×10¹⁶ cm⁻³.

**[Table 2]**

| Li/Spiro-OMeTAD (Molar ratio) | Efficiency (%) | J_{SC} (mA cm⁻²) | V_{OC} (mV) | FF(%) |
|---|---|---|---|---|
| Less than 0.6 | 15.4 | 21.2 | 1195.1 | 60.6 |
| 0.6 or more and less than 0.8 | 17.3 | 21.8 | 1169.1 | 67.9 |
| 0.8 or more and less than 1.0 | 17.9 | 21.9 | 1150.9 | 71.1 |
| 1.0 or more | 17.5 | 21.5 | 1139.9 | 71.4 |

As shown in Table 2, it can be seen that when the lithium concentration of the additive is more than 0.6 in terms of molar ratio with Spiro-OMeTAD, the efficiency is higher than that when the molar ratio is less than 0.6. In the photoelectric conversion element having a structure in which the transparent conductive layer and the hole transport layer are in contact with each other, the optimum value of the doping concentration of lithium into the hole transport layer is generally about 0.5.

### (Carrier Density of Hole Transport Layer and Device Characteristics)

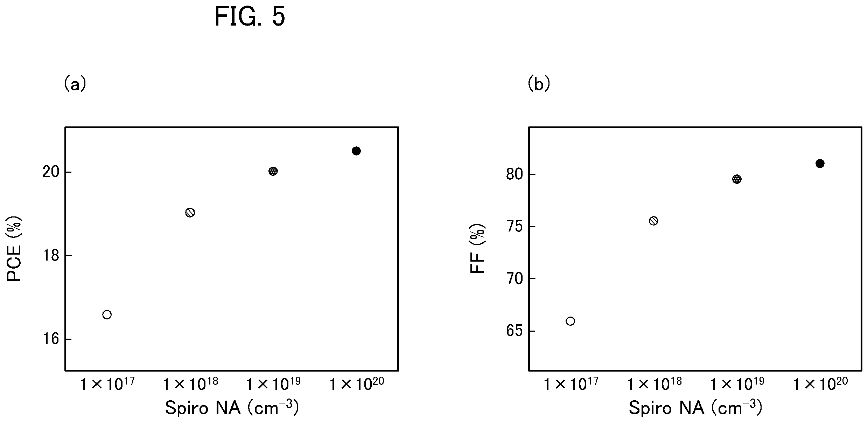

In addition, the value of the device characteristic with respect to the carrier density of the hole transport layer was obtained by simulation using a solar cell capacitance simulator (SCAPS). Fig. 5 illustrates a result of the simulation. The horizontal axes in Figs. 5(a) and 5(b) indicate the carrier density of the hole transport layer (Spiro-OMeTAD), respectively. The vertical axis of Fig. 5(a) represents the energy conversion efficiency (PCE), and the vertical axis of Fig. 5(b) represents the fill factor (FF).

As illustrated in Figs. 5(a) and 5(b), in a case where the carrier density of the hole transport layer is 1×10¹⁸ cm⁻³ or more, both the energy conversion efficiency and the fill factor are higher than those when the carrier density is 1×10¹⁷ cm⁻³. Therefore, it can be seen that the carrier density of the hole transport layer is preferably 1×10¹⁸ cm⁻³ or more in order to exhibit the tunnel effect.

### (Thickness of Hole Transport Layer and Device Characteristics)

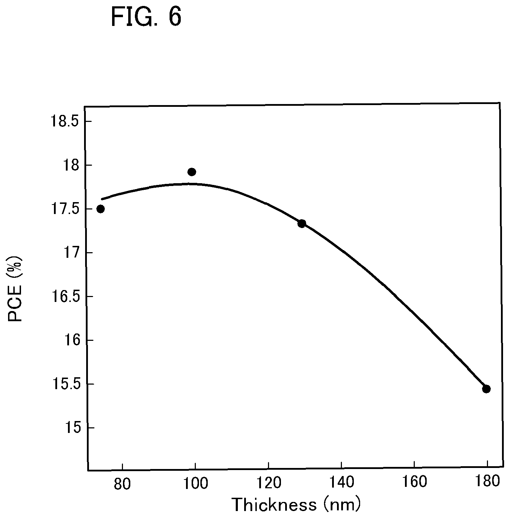

In addition, in the solar cell to be evaluated, the relationship of the device characteristics of the solar cell with respect to the thickness of the hole transport layer is shown in Fig. 6. The horizontal axis in Fig. 6 indicates the thickness of the hole transport layer (Spiro-OMeTAD). In Fig. 6, the vertical axis represents the energy conversion efficiency (PCE).

As illustrated in Fig. 6, when the thickness of the hole transport layer is in the range of 75 nm or more and 130 nm or less, the energy conversion efficiency shows an actual measurement value exceeding 17%. However, when the thickness of the hole transport layer becomes 180 nm, the actually measured value of the energy conversion efficiency decreases to about 15.5%. As described above, it is apparent that the thickness of the hole transport layer is preferably 130 nm or less in order to further improve the carrier density of the hole transport layer by oxidation by sputtering.

### (Power Density during Sputtering Deposition of Transparent Conductive Layer)

In addition, in the solar cell to be evaluated, the relationship between the device characteristics of the solar cell and the power density during sputtering deposition of the transparent conductive layer in contact with the hole transport layer is shown in Table 3. In Table 3, the material of the transparent conductive layer was ITO, and O/(Ar + O) during sputtering film formation was fixed at 2.5%.

**[Table 3]**

| Power density (W/cm²) | Efficiency (%) | J_{SC} (mA cm⁻²) | V_{OC} (mV) | FF(%) |
|---|---|---|---|---|
| 0.3 | 9.3 | 21.1 | 897.7 | 49.0 |
| 0.8 | 15.2 | 21.4 | 1197.9 | 59.5 |
| 1.6 | 15.4 | 21.2 | 1195.1 | 60.6 |

As shown in Table 3, the efficiency is 9.3% when the power density during sputtering film formation is 0.3 W/cm², whereas the efficiency exceeds 15% when the power density is 0.8 W/cm² or more. As described above, it is apparent that the power density during sputtering deposition is preferably 0.8 W/cm² or more in order to promote oxidation of the hole transport layer by oxygen plasma during sputtering deposition to increase the carrier density of the hole transport layer.

### (Oxygen Concentration of Gas during Sputtering Deposition of Transparent Conductive Layer)

In addition, in the solar cell to be evaluated, the relationship between the carrier density of the transparent conductive layer and the oxygen concentration (O/(Ar + O)) of the carrier gas during sputtering deposition of the transparent conductive layer is shown in Table 4. In Table 4, the material of the transparent conductive layer is ITO.

**[Table 4]**

| O/(Ar+O) (%) | Transparent conductive layer N (cm⁻³) |
|---|---|
| 0 | 4 × 10²⁰ |
| 0.5 | 1 × 10²⁰ |
| 1.5 | 6 × 10¹⁹ |
| 2.5 | 6 × 10¹⁶ |

As shown in Table 4, the carrier density of the transparent conductive layer decreases as the oxygen concentration (O/(Ar + O)) of the carrier gas increases. When the oxygen concentration of the carrier gas is 0.5% or more, the carrier density of the transparent conductive layer in contact with the hole transport layer can be set to 1×10²⁰ cm⁻³ or less.

### (Presence or Absence of Buffer Layer and Device Characteristics)

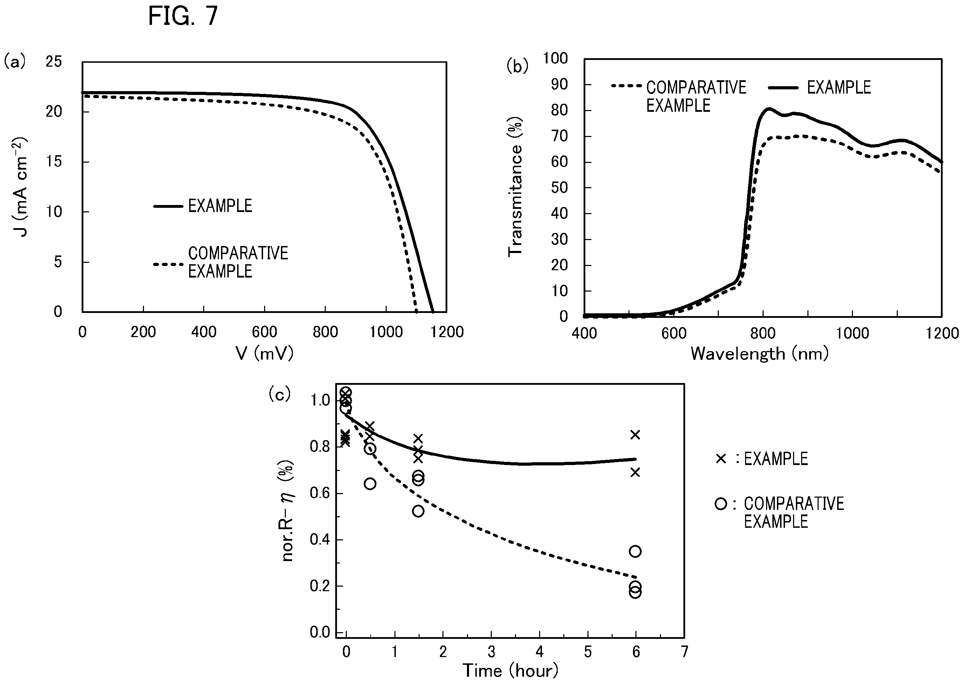

Next, device characteristics of an example of the present embodiment and a comparative example having a buffer layer of MoOₓ will be described with reference to Fig. 7. Here, in Examples, there is no buffer layer of MoOₓ, the carrier density of ITO is 6.4×10¹⁶ cm⁻³, and the molar ratio of Li/Spiro-OMeTAD is 0.81.

Fig. 7(a) is a graph showing J-V characteristics of examples and comparative examples. In Fig. 7(a), the vertical axis represents the current (mA cm⁻²), and the horizontal axis of Fig. 7(a) represents the voltage (mV). In Fig. 7(a), it can be seen that the example exhibits higher efficiency than the comparative example having the buffer layer.

Fig. 7(b) is a graph showing transmission spectra of examples and comparative examples. In Fig. 7(b), the vertical axis represents transmittance (%), and the horizontal axis of Fig. 7(b) represents wavelength (nm). In Fig. 7(b), it can be seen that the example exhibits high transmittance in any wavelength range as compared with the comparative example having the buffer layer.

Fig. 7(c) is a graph illustrating the time transition of the conversion efficiency of examples and comparative examples at the time of heating at 85°C. The vertical axis of Fig. 7(c) represents the energy conversion efficiency, and the horizontal axis of Fig. 7(c) represents time (hour). In Fig. 7(c), it can be seen that a decrease in efficiency during heating is suppressed in the example as compared with the comparative example having the buffer layer.

Various device characteristics of examples and comparative examples are shown in Table 5. As compared with the comparative example having a buffer layer, the example shows high performance in terms of efficiency, 800 to 1200 nm average transmittance, and retention rate.

**[Table 5]**

| | Efficiency (%) | J_{SC} (mA cm⁻²) | V_{OC} (mV) | FF(%) | 800-1200nm Average transmittance(%) | Retention rate (%) |
|---|---|---|---|---|---|---|
| Example | 17.9 | 21.9 | 1150.9 | 71.1 | 75.8 | 80% |
| Comparative Example (MoOx buffer) | 16.5 | 21.7 | 1102.8 | 69.0 | 68.3 | 30% |

### <Supplementary Matters of Embodiments>

In the above embodiment, the configuration example of the perovskite solar cell has been described as an example of the photoelectric conversion element. However, the configuration of the photoelectric conversion element of the present invention may be applied to, for example, a photodiode, an optical sensor, or the like.

In the above embodiment, the configuration of a single-junction cell as one solar cell and the configuration of a multi-junction solar cell in which two layers of solar cells are stacked have been described. However, the configuration of the photoelectric conversion element of the present invention can be similarly applied to a multi-junction solar cell in which three or more layers of solar cells are stacked. In this case, the configuration of the photoelectric conversion element of the present invention is not limited to the top cell, and can be applied to any cell.

As described above, the embodiment of the present invention has been described, but the embodiment is presented as an example, and is not intended to limit the scope of the present invention. The embodiments can be implemented in various forms other than the above, and various omissions, substitutions, changes, and the like can be made without departing from the gist of the present invention. Embodiments and modifications thereof are included in the scope and gist of the present invention, and the invention described in the claims and equivalents thereof are also included in the scope and gist of the present invention.

The present application claims priority based on Japanese Patent Application No. 2021-205450 filed on December 17, 2021, and the entire contents of Japanese Patent Application No. 2021-205450 are incorporated herein by reference.

### Reference Signs List

- 10, 10A: Solar cell
- 11: Substrate
- 12: First conductive layer
- 13: Electron transport layer
- 13a: Dense layer
- 13b: Porous layer
- 14: Light absorbing layer
- 15: Hole transport layer
- 16: Second conductive layer
- 17: Third conductive layer
- 21: First electrode layer
- 22: Photoelectric conversion layer
- 23: Buffer layer
- 24: Second electrode layer
- TC: Top cell
- BC: Bottom cell

## Claims

1. A photoelectric conversion element comprising:
a light absorbing layer;
a hole transport layer that transports holes generated by photoexcitation of the light absorbing layer; and
a transparent conductive layer that is in contact with the hole transport layer and receives the holes from the hole transport layer,
wherein a carrier density of the transparent conductive layer is more than 1×10¹⁶ cm⁻³ and 1×10²⁰ cm⁻³ or less.

2. The photoelectric conversion element according to claim 1,
wherein the hole transport layer contains an additive that oxidizes the hole transport layer to increase the carrier density of the hole transport layer.

3. The photoelectric conversion element according to claim 2,
wherein the additive contains lithium.

4. The photoelectric conversion element according to claim 3,
wherein a concentration ratio between the material of the hole transport layer and the lithium is 0.6 or more.

5. The photoelectric conversion element according to any one of claims 2 to 4,
wherein the additive is lithium
(fluorosulfonyl)(trifluoromethyl)imide (LiTFSI).

6. The photoelectric conversion element according to any one of claims 1 to 5,
wherein the carrier density of the hole transport layer is 1×10¹⁸ cm⁻³ or more.

7. The photoelectric conversion element according to any one of claims 1 to 6,
wherein a thickness of the hole transport layer is 130 nm or less.

8. The photoelectric conversion element according to any one of claims 1 to 7,
wherein the transparent conductive layer is formed of a metal oxide containing any of indium, zinc, and tin, and
the hole transport layer contains Spiro-OMeTAD.

9. The photoelectric conversion element according to any one of claims 1 to 8,
wherein the light absorbing layer contains a compound having a perovskite structure.

10. The photoelectric conversion element according to any one of claims 1 to 9,
wherein the photoelectric conversion element is a solar cell stacked on a bottom cell of a multi-junction solar cell.

11. A manufacturing method of a photoelectric conversion element, comprising the steps of:
forming a light absorbing layer;
forming a hole transport layer that transports holes generated by photoexcitation of the light absorbing layer; and
forming a transparent conductive layer that is in contact with the hole transport layer and receives the holes from the hole transport layer,
wherein a carrier density of the transparent conductive layer is more than 1×10¹⁶ cm⁻³ and 1×10²⁰ cm⁻³ or less.

12. The manufacturing method of the photoelectric conversion element according to claim 11,
wherein the hole transport layer contains an additive that oxidizes the hole transport layer, and
the hole transport layer is exposed to oxygen plasma.

13. The manufacturing method of the photoelectric conversion element according to claim 12,
wherein the oxygen plasma is generated by discharge when the transparent conductive layer is formed by a sputtering method, and
a power density of the discharge is 0.8 W/cm² or more.

14. The manufacturing method of the photoelectric conversion element according to claim 12 or 13,
wherein an oxygen concentration of a gas introduced at a time of generating the oxygen plasma is 0.5% or more.
